# EUROPEAN PATENT APPLICATION

(11) **EP 4 770 370 A1**
(43) Date of publication of application: **01.07.2026**
(21) Application number: 25219010.3
(22) Date of filing: 27.11.2025
(51) Int. Cl.: H10K 59/123, H10K 59/131

(54) **DISPLAY PANEL**

(30) Priority: 30.12.2024 KR 20240200208
(71) Applicant: LG Display Co., Ltd., Seoul 150-721 (KR)
(72) Inventor: YANG, Jung Yul, 10845 Paju-si, Gyeonggi-do (KR); MOON, Tae Hyoung, 10845 Paju-si, Gyeonggi-do (KR); JUNG, Ju Hee, 10845 Paju-si, Gyeonggi-do (KR)
(74) Representative: Viering, Jentschura & Partner mbB Patent- und Rechtsanwälte

(57) **Abstract**

Disclosed is a display panel (10). The display panel (10) includes a substrate (100), a switching transistor (ST) disposed on the substrate (100) and including a first gate electrode (G1), a first source electrode (SSDla), a first drain electrode (SSD1b), and a first active layer (ACT1), a driving transistor (DT) disposed on the substrate (100) to be spaced apart from the switching transistor (ST) and including a second gate electrode (G2), a second source electrode (DSD1a), a second drain electrode (DSD1b), and a second active layer (ACT2), a light-emitting element (OLED) including an anode (AND) conductively connected to one electrode of the second source electrode (DSDla) and the second drain electrode (DSD1b) of the driving transistor (DT), an emission layer (EL) located on the anode (AND), and a cathode (CTD) located on the emission layer (EL), an intermediate electrode (SD2) configured to conductively connect the one electrode of the second source electrode (DSD1a) and the second drain electrode (DSD1b) of the driving transistor (DT) to the anode (AND), wherein the first active layer (ACT1) of the switching transistor (ST) overlaps at least one of the anode (AND) and the intermediate electrode (SD2), and at least a portion of the second active layer (ACT2) of the driving transistor (DT) does not overlap the anode (AND) and the intermediate electrode (SD2).

## Description

### TECHNICAL FIELD

The present disclosure relates to a display panel.

### BACKGROUND ART

Display devices that display images in TVs, monitors, smartphones, tablet PCs, and laptops are used in various ways and forms.

The display devices include a display panel having a plurality of light-emitting elements or liquid crystals configured to implement images, and transistors configured to control operation of each light-emitting element or liquid crystal so as to display images to be displayed through the plurality of light-emitting elements or liquid crystals.

The display device includes a plurality of pixels including the light-emitting elements, and is provided with a plurality of driving and switching elements to drive and control light-emitting elements in each pixel. The driving and switching elements may include transistors.

Recently, a variety of research and development has been conducted to improve performance and reliability of transistors.

### SUMMARY OF THE DISCLOSURE

Accordingly, the present disclosure is directed to a display panel that substantially obviates one or more problems due to limitations and disadvantages of the related art.

An object of the present disclosure is to provide a display panel having improved characteristics for positive bias thermal stress (PBTS) of transistors provided in subpixels.

Additional advantages, objects, and features of the disclosure will be set forth in part in the description which follows and in part will become apparent to those having ordinary skill in the art upon examination of the following or may be learned from practice of the disclosure. The objectives and other advantages of the disclosure may be realized and attained by the structure particularly pointed out in the written description and claims hereof as well as the appended drawings.

To achieve these objects and other advantages and in accordance with the purpose of the disclosure, as embodied and broadly described herein, a display panel according to claim 1 is provided. Further embodiments are described in the dependent claims. According to an aspect of the present disclosure, a display panel includes a substrate, a switching transistor disposed on the substrate and including a first gate electrode, a first source electrode, a first drain electrode, and a first active layer, a driving transistor disposed on the substrate to be spaced apart from the switching transistor and including a second gate electrode, a second source electrode, a second drain electrode, and a second active layer, a light-emitting element comprising an anode conductively connected to one electrode of the second source electrode and the second drain electrode of the driving transistor, an emission layer located on the anode, and a cathode located on the emission layer, and an intermediate electrode configured to conductively connect the one electrode of the second source electrode and the second drain electrode of the driving transistor to the anode, wherein the first active layer of the switching transistor overlaps at least one of the anode and the intermediate electrode, and at least a portion of the second active layer of the driving transistor does not overlap the anode and the intermediate electrode.

An entirety of the first active layer of the switching transistor may overlap the at least one of the anode and the intermediate electrode.

The first active layer and/or the second active layer may include an oxide semiconductor.

The second active layer of the driving transistor may include non-exposed areas configured to overlap the second gate electrode, the second source electrode, and the second drain electrode, and exposed areas configured not to overlap the second gate electrode, the second source electrode, and the second drain electrode, and at least the exposed areas of the second active layer of the driving transistor may not overlap the anode and the intermediate electrode.

The display panel may further include a bank. At least the exposed areas of the second active layer of the driving transistor may overlap the bank.

The bank may include a light-absorbing material. The bank may have bank holes formed through some areas thereof, and at least one of the emission layer or the cathode may be located in the bank holes. The anode may not overlap the bank holes. The bank holes may overlap the exposed areas of the second active layer of the driving transistor.

A color filter may be disposed above the light-emitting element, and a black matrix may be disposed on sides of the color filter. The black matrix may have black matrix (BM) holes formed through some areas thereof. The BM holes may overlap the bank holes, and may overlap the exposed areas of the second active layer of the driving transistor.

It is to be understood that both the foregoing general description and the following detailed description of the present disclosure are exemplary and explanatory and are intended to provide further explanation of the disclosure as claimed.

### BRIEF DESCRIPTION OF THE DRAWINGS

The accompanying drawings, which are included to provide a further understanding of the disclosure and are incorporated in and constitute a part of this application, illustrate embodiment(s) of the disclosure and together with the description serve to explain the principle of the disclosure. In the drawings:
FIG. 1 is a diagram illustrating an example of a display device according to the present disclosure;
FIG. 2 is a diagram illustrating an example of an equivalent circuit for a subpixel according to the display device of the present disclosure;
FIG. 3 is a diagram illustrating a cross-sectional structure of a display panel according to one embodiment of the present disclosure;
FIG. 4 is a diagram illustrating an overlapping relationship between an anode and an intermediate electrode and an overlapping relationship between a switching transistor and a driving transistor in the subpixel according to the present disclosure;
FIGs. 5(a) and 5(b) are diagrams illustrating a non-overlapping portion of the driving transistor in the subpixel according to the present disclosure in more detail;
FIGs. 6(a) and 6(b) are diagrams illustrating the principle in which the positive bias thermal stress (PBTS) of the driving transistor is offset; and
FIG. 7 is a diagram illustrating a cross-sectional structure of a display panel according to another embodiment of the present disclosure.

### DETAILED DESCRIPTION OF THE DISCLOSURE

Hereinafter, embodiments will be described with reference to the accompanying drawings.

The same reference numerals or symbols in different drawings indicate similar or identical components. In addition, some of the drawings may be exaggerated for effective explanation of the thicknesses, ratios, and dimensions of components. Components illustrated in the drawings may have a different scale from the actual scale for convenience of explanation, and are not limited to the scale illustrated in the drawings.

In the following description, when an element (region, layer, part, or the like) is referred to as being "on," "connected to," or "coupled to" another component, it may be directly on, connected to, or coupled to the other component, or intervening components may be present.

As used herein, the term "and/or" includes any and all combinations of one or more of the associated listed items.

Terms, such as "first," "second," and the like, are used to describe various elements, and these elements should not be construed as being limited by these terms. These terms are used only to distinguish one element from other elements. For example, a first element described hereinafter may be termed a second element, and similarly, a second element described hereinafter may be termed as a first element, without departing from the scope of the disclosure. Singular expressions may encompass plural expressions, unless they have clearly different contextual meanings.

Terms, such as "below," "under," "above," "on," and the like, may be used to describe the relationship between components illustrated in the drawings The terms are relative concepts, and are described based on the orientation illustrated in the drawings. For example, one or more other parts may be located between two parts unless "directly" or "immediately" is used. Spatially relative terms, such as "below," "beneath," "lower," "above," "upper," and the like, may be used herein for ease of description to describe a relation between one element or component and another element or component as illustrated in the drawings. For example, "below" or "lower" with respect to a first component may be in the opposite direction to "above" or "upper" with respect to the first component.

It will be understood that the spatially relative terms may encompass different orientations of an element in use or operation in addition to the orientation depicted in the figures. For example, if an element in the figures is inverted, elements described as "below" or "beneath" other elements would then be oriented "over" the other elements. Thus, the exemplary term "below" may encompass both an orientation of below and above.

The terms "comprises," "comprising," "including," and "having" are inclusive and therefore specify the presence of stated features, integers, operations, elements, components, and/or combinations thereof, but do not preclude the possibility the presence or addition of one or more other features, integers, operations, elements, components, and/or combinations thereof.

Individual features of various embodiments in the following description may be partially or wholly coupled to or combined with each other, and may be technically interconnected and operated in various ways, and the respective embodiments may be implemented independently of each other or implemented together in a related manner.

Hereinafter, a display device according to the present disclosure will be described with reference to the accompanying drawings and embodiments.

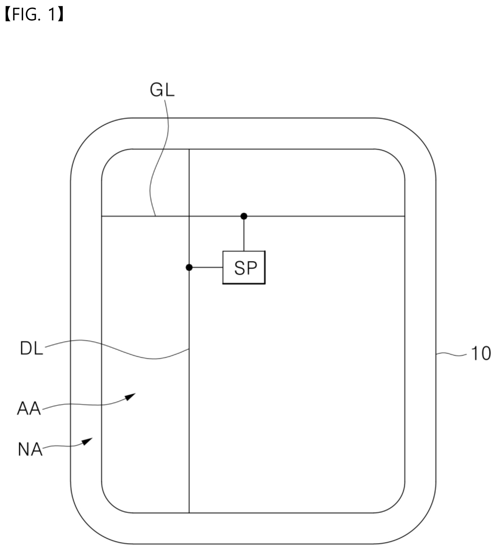

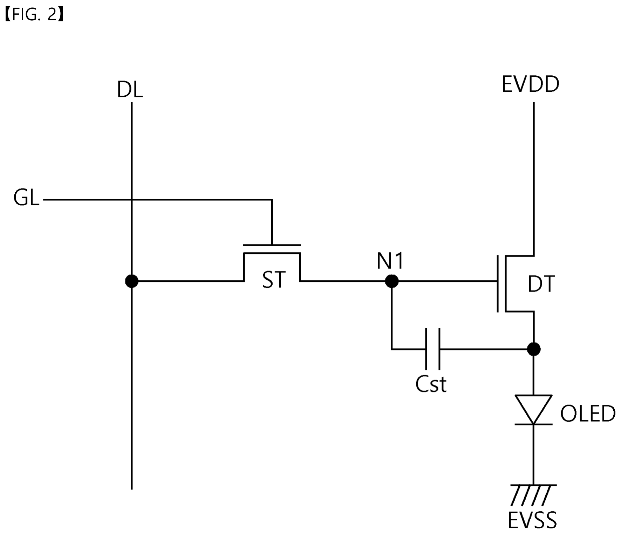

FIG. 1 is a diagram illustrating an example of the display device according to the present disclosure, and FIG. 2 is a diagram illustrating an example of an equivalent circuit for a subpixel according to the present disclosure.

Referring to FIGs. 1 and 2, a display device according to one embodiment of the present disclosure may include a display panel 10, and the display panel 10 may include an active area AA and a non-active area NA.

The active area AA may be an area that displays an image. A plurality of subpixels SP may be disposed in the active area AA of the display panel 10, and an image may be displayed using the plurality of subpixels SP. The area where the plurality of subpixels SP is disposed may serve as the active area AA, and an area other than the active area AA may serve as the non-active area NA.

The non-active area NA may be disposed in an edge area surrounding the active area AA that displays an image. At least one driving unit to drive the plurality of subpixels SP may be disposed in the non-active area NA. For example, a scan driver that sequentially supplies scan signals to a plurality of gate lines GL may be provided as a gate-in-panel (GIP) in the non-active area NA. In addition, various additional elements to drive the subpixels SP in the active area AA may be further disposed in the non-active area NA.

At least one subpixel SP among the plurality of subpixels SP may be provided with, for example, a circuit including a switching transistor ST, a driving transistor DT, a capacitor Cst, and a light-emitting element OLED, as shown in FIG. 2.

A first electrode (e.g., a drain electrode) of the switching transistor ST may be conductively connected to a data line DL, a second electrode (e.g., a source electrode) of the switching transistor ST may be conductively connected to a first node N1, and a gate electrode of the switching transistor ST may be conductively connected to the gate line GL. The switching transistor ST may transmit a data signal supplied through the data line DL to the first node N1 in response to the scan signal supplied through the gate line GL.

The capacitor Cst may be conductively connected to the first node N1 to charge the first node N1 with a voltage applied thereto.

A first electrode (e.g., a drain electrode) of the driving transistor DT may receive a high-potential driving voltage EVDD, and a second electrode (e.g., a source electrode) of the driving transistor DT may be conductively connected to a first electrode (e.g., an anode) of the light-emitting element OLED. The driving transistor DT may generate a driving current flowing to the light-emitting element OLED in response to a voltage applied to a gate electrode of the driving transistor DT.

An active layer of the switching transistor ST and/or the driving transistor DT may include an oxide semiconductor, such as indium-gallium-zinc-oxide (IGZO), but is not limited thereto.

The light-emitting element OLED may output light corresponding to the driving current. The light-emitting element OLED may output light corresponding to one color among red R, green G, blue B, and white W.

The light-emitting element OLED may include the anode, an emission layer disposed on the anode, and a cathode that supplies a common voltage.

The driving current generated by the driving transistor DT may be applied to the anode of the light-emitting element OLED, and the cathode of the light-emitting element OLED may receive a low-potential driving voltage EVSS.

The emission layer may be implemented to emit light of the same color for each subpixel SP, such as white light, or may be implemented to emit light of different color for each subpixel SP, such as red light, green light, or blue light. The light-emitting element OLED may be a top emission-type diode or a bottom emission-type diode.

Although FIG. 2 illustrates a case in which the driving transistor DT is directly connected to the light-emitting element OLED, the present disclosure is not limited thereto, and the driving transistor DT may be conductively connected to the light-emitting element OLED through another switching transistor ST.

In addition, although not shown in FIG. 2, a compensation circuit (not shown) to compensate for a threshold voltage Vth of the driving transistor DT, which is a driving transistor DT, may be further provided in the subpixel SP. The compensation circuit may include at least one transistor connected to the driving transistor DT, and be provided in the subpixel SP.

Depending on the configuration of the compensation circuit, the compensation circuit may be provided in various structures, such as 3T1C including three transistors and one capacitor Cst in the subpixel SP, 4T1C including four transistors and one capacitor Cst in the subpixel SP, 5T2C, 6T1C, 6T2C, 7T1C, 7T2C, etc.

Further, in the above-described display panel 10, the switching transistor ST having the gate electrode connected to the gate line GL has a very short period of time during which a gate high voltage is applied through the gate line within one frame period, and a switching transistor included in the compensation circuit also has a very short period of time during which a gate high voltage is applied within one frame period, and may thus hardly receive positive bias thermal stress (PBTS).

However, the driving transistor DT has a very long period of time during which a positive (+) voltage is applied to the gate electrode by the compensation circuit, etc., and may thus have a relatively large PBTS, and as a result, the threshold voltage Vth of the driving transistor DT may shift positively, and the driving current generated by the driving transistor DT may decrease.

Therefore, as the driving time of the driving transistor DT becomes longer, the deterioration of the driving transistor DT becomes more severe, and thus, the positive shift of the threshold voltage Vth may become more severe, and the decrease in the driving current may increase, so that the brightness of the light-emitting element OLED may decrease in proportion to the driving time.

Considering this, the present disclosure may allow at least a portion of the active layer of the driving transistor DT to be exposed to external light while preventing the active layer of the switching transistor ST from being exposed to the external light, in order to suppress the decrease in the brightness of the display panel 10 caused by the deterioration of the threshold voltage Vth of the driving transistor DT due to the PBTS.

For this purpose, the present disclosure may allow, for example, at least one of the anode and an intermediate electrode located above the switching transistor ST and the driving transistor DT to overlap the active layer of the switching transistor ST, and the anode and the intermediate electrode not to overlap at least a portion of the active layer of the driving transistor DT. That is, the present disclosures may prevent the anode and the intermediate electrode from overlapping at least a portion of the active layer of the driving transistor DT.

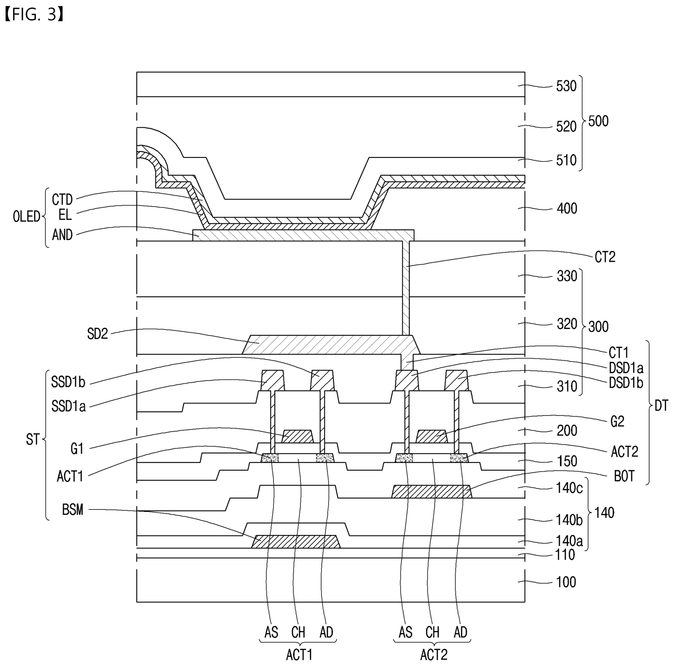

This will be described below in detail with reference to FIG. 3.

FIG. 3 is a diagram illustrating a cross-sectional structure of the display panel according to one embodiment of the present disclosure.

The example of the cross-sectional structure of the display panel shown in FIG. 3 may represent a cross-sectional structure of a subpixel. As shown in FIG. 3, the cross-sectional structure of the display panel 10 according to one embodiment of the present disclosure may include a substrate 100, a substrate insulating film 110, a buffer layer 140, a gate insulating film 150, an interlayer insulating film 200, a planarization film 300, an intermediate electrode SD2, a bank 400, the light-emitting element OLED, an encapsulation layer 500, the switching transistor ST, and the driving transistor DT.

The substrate 100 may be formed of a flexible plastic material so as to have flexibility, or may include a thin flexible glass material. The substrate 100 may be disposed in the active area AA and the non-active area NA of the display panel 10.

The substrate insulating film 110 may be disposed in the active area AA and the non-active area NA on the substrate 100. The substrate insulating film 110 may be disposed on the substrate 100 to protect structures on the substrate 100, which are vulnerable to moisture, from moisture penetrating through the substrate 100. The substrate insulating film 110 may include at least one inorganic film of a silicon oxide film (SiOₓ), a silicon nitride film (SiNₓ), or a silicon oxynitride film (SiOₓN_{y}). A first metal layer BSM may be disposed on the substrate insulating film 110 to stabilize operation of the switching transistor ST.

The first metal layer BSM may be conductively connected to, for example, one electrode of a first source electrode SSD1a and a first drain electrode SSD1b of the switching transistor ST, or be connected to a first gate electrode G1 of the switching transistor ST.

The buffer layer 140 may be provided on the substrate insulating film 110 while covering the first metal layer BSM. The buffer layer 140 may include an inorganic insulating material, such as silicon oxide (SiOₓ) or silicon nitride (SiNₓ). The buffer layer 140 may include a multilayer structure including the same material or different materials. For example, the buffer layer 140 may include first, second, and third buffer layers 140a, 140b, and 140c.

The first buffer layer 140a may be stacked on the substrate insulating film 110 while covering the first metal layer BSM, the second buffer layer 140b may be stacked on the first buffer layer 140a, a second metal layer BOT may be disposed on the second buffer layer 140b to stabilize operation of the driving transistor DT, and the third buffer layer 140c may be stacked on the second buffer layer 140b while covering the second metal layer BOT.

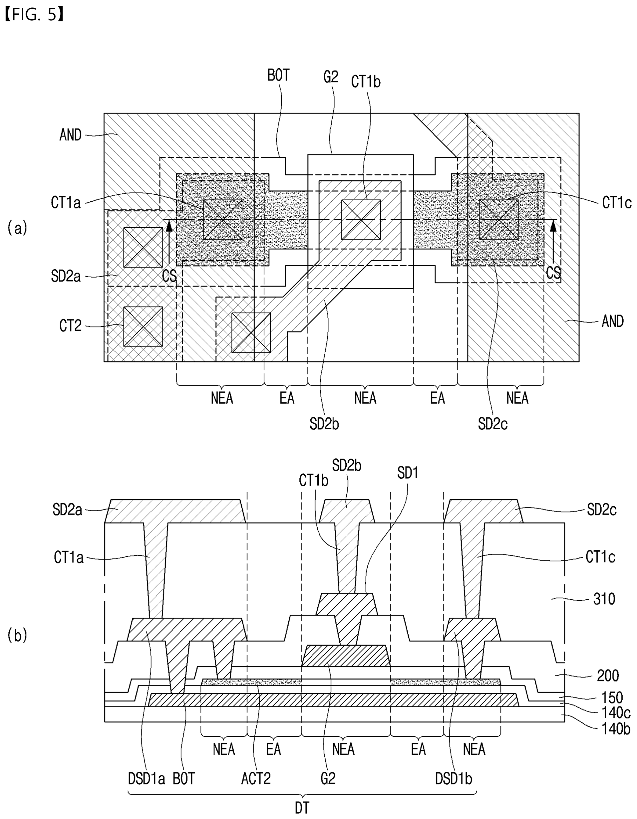

The second metal layer BOT may be conductively connected to, for example, one electrode of a second source electrode DSD1a and a second drain electrode DSD1b of the driving transistor DT, or be connected to a second gate electrode G2 of the driving transistor DT. In this description, as an example, referring to FIGs. 5(a) and 5(b), a case in which the second metal layer BOT is conductively connected to one electrode of the second source electrode DSD1a and the second drain electrode DSD1b of the driving transistor DT is illustrated.

The switching transistor ST and the driving transistor DT may be disposed on the buffer layer 140. The switching transistor ST may include the first gate electrode G1, the first source electrode SSD1a, the first drain electrode SSD1b, and a first active layer ACT1, and the driving transistor DT may be disposed to be spaced apart from the switching transistor ST, and include the second gate electrode G2, the second source electrode DSD1a, the second drain electrode DSD1b, and a second active layer ACT2.

As shown in FIG. 3, each of the first and second active layers ACT1 and ACT2 may include a source region AS, a channel region CH, and a drain region AD. The source region AS and the drain region AD may have higher electrical conductivity and carrier concentration than the channel region CH, and the channel region CH may have lower carrier concentration than the source region AS and the drain region AD, and may form a channel in response to a voltage applied to the gate electrode G.

The gate insulating film 150 may be stacked on the buffer layer 140 while covering the first and second active layers ACT1 and ACT2. The gate insulating film 150 may insulate between the gate electrode G and the active layer ACT of each transistor. The gate insulating film 150 may include an inorganic insulating material, such as silicon oxide (SiOₓ), silicon nitride (SiNₓ), or silicon oxynitride (SiOₓN_{y}).

The interlayer insulating film 200 may be located on the gate insulating film 150 to cover the first and second gate electrodes G1 and G2. The first source electrode SSD1a and the first drain electrode SSD1b of the switching transistor ST and the second source electrode DSD1a and the second drain electrode DSD1b of the driving transistor DT may be located on the interlayer insulating film 200. The interlayer insulating film 200 may include an inorganic insulating material, such as silicon oxide (SiOₓ), silicon nitride (SiNₓ), or silicon oxynitride (SiOₓN_{y}).

The first source electrode SSD1a and the first drain electrode SSD1b of the switching transistor ST may penetrate the interlayer insulating film 200 and the gate insulating film 150 and come into contact with the source region AS and the drain region AD provided in the first active layer ACT1 of the switching transistor ST, and the second source electrode DSD1a and the second drain electrode DSD1b of the driving transistor DT may penetrate the interlayer insulating film 200 and the gate insulating film 150 and come into contact with the source region AS and the drain region AD provided in the second active layer ACT2 of the driving transistor DT.

The planarization film 300 may be stacked on the interlayer insulating film 200 to cover the first source electrode SSD1a and the first drain electrode SSD1b of the switching transistor ST and the second source electrode DSD1a and the second drain electrode DSD1b of the driving transistor DT. The planarization film 300 may remove steps caused by a driving circuit and have a flat upper surface. The planarization film 300 may include an organic insulating material having high fluidity.

The planarization film 300 may be provided by stacking a plurality of layers. For example, as shown in FIG. 3, a first planarization film 310, a second planarization film 320, and a third planarization film 330 may be stacked. The upper surfaces of the first, second, and third planarization films 310, 320, and 330 may be flat.

The first planarization film 310 may be stacked on the interlayer insulating film 200 to cover the switching transistor ST and the driving transistor DT, and the intermediate electrode SD2 may be disposed on the upper surface of the first planarization film 310.

The second planarization film 320 may be disposed on the first planarization film 310 while covering the intermediate electrode SD2, and the third planarization film 330 may be disposed on the second planarization film 320. FIG. 3 illustrates a case in which the planarization film 300 is formed by stacking three films as an example, but the present disclosure is not limited to the number of films stacked to form the planarization film 300.

Here, the intermediate electrode SD2 may conductively connect one electrode of the second source electrode DSD1a and the second drain electrode DSD1b of the driving transistor DT to an anode AND of the light-emitting element OLED. For example, the intermediate electrode SD2 may be conductively connected to one electrode provided in the driving transistor DT through a first contact portion CT1 penetrating the first planarization film 310, and the anode AND may be conductively connected to the intermediate electrode SD2 through a second contact portion CT2 penetrating the second and third planarization films 320 and 330.

Accordingly, one electrode provided in the driving transistor DT may be in electrical contact with the anode AND of the light-emitting element OLED.

The bank 400 may be located on the third planarization film 330. The bank 400 may include an organic insulating material. The bank 400 may cover the edge of the anode AND. An emission layer EL and a cathode CTD may be on a portion of the anode AND exposed by the bank 400. For example, the bank 400 may define an emission area of each subpixel SP. The emission area of each subpixel SP may be distinguished by the bank 400.

The light-emitting element OLED may be located in the emission area, and include the anode AND, the emission layer EL, and the cathode CTD. FIG. 3 illustrates a case in which portions of the emission layer EL and the cathode CTD are located on the bank 400 as an example, but the present disclosure is not limited thereto.

The display panel 10 of the present disclosure may have, for example, a top emission structure in which light emitted from the light-emitting element OLED is emitted in the upward direction of the substrate 100 on which the light-emitting element OLED is disposed.

For this purpose, the anode AND may include a conductive material, and may include a structure in which a reflective layer (not shown) is stacked on the lower surface of a transparent conductive layer (not shown). The transparent conductive layer may be formed of, for example, a transparent conductive oxide, such as ITO, IZO, or the like, and the reflective layer may be formed of, for example, silver (Ag), aluminum (Al), gold (Au), molybdenum (Mo), tungsten (W), chromium (Cr), or an alloy thereof.

Accordingly, the anode AND may reflect light incident from the upper surface thereof where the emission layer EL is located, through the high reflectivity of the reflective layer.

The emission layer EL may generate light with a brightness corresponding to a voltage difference between the anode AND and the cathode CTD. For example, the emission layer EL may include an emission material layer EML including a light-emitting material. The light-emitting material may include an organic material, an inorganic material, or a hybrid material. For example, the emission layer EL may include the emission material layer EML formed of an organic material.

The cathode CTD may include a conductive material. The cathode CTD may include a different material from the anode AND. For example, the cathode CTD may be a transparent electrode formed of a transparent conductive material, such as ITO or IZO. The cathode CTD may have a higher transmittance than the anode AND.

For example, the cathode CTD may be formed of a transparent metal oxide, such as indium tin oxide (ITO) or indium zinc oxide (IZO), but is not limited thereto. When the display device is a top emission type, the cathode CTD may be formed of a translucent conductive material that transmits light. For example, the cathode CTD may be formed of at least one alloy of LiF/Al, CsF/Al, Mg:Ag, Ca/Ag, Ca:Ag, LiF/Mg:Ag, LiF/Ca/Ag, or LiF/Ca:Ag.

The encapsulation layer 500 may be disposed on the cathode CTD on the emission layer EL and prevent damage to the light-emitting element OLED due to external impact and moisture. The encapsulation layer 500 may be formed by alternately stacking inorganic insulating material layers and organic insulating material layers. For example, as shown in FIG. 3, the encapsulation layer 500 may include first, second, and third encapsulation layers 510, 520, and 530. The first and third encapsulating layers 510 and 530 may include inorganic insulating material layers, and the second encapsulating layer 520 may include an organic insulating material layer.

In the structure of the display panel 10 shown in FIG. 3, the present disclosure may allow at least one of the anode AND and the intermediate electrode SD2 to overlap the first active layer ACT1 of the switching transistor ST and allow the anode AND and the intermediate electrode SD2 not to overlap at least a portion of the second active layer ACT2 of the driving transistor DT, in order to suppress the decrease in the brightness of the display panel 10 caused by the deterioration of the threshold voltage Vth of the driving transistor DT due to the PBTS.

For example, as shown in FIG. 3, the anode AND and the intermediate electrode SD2 may overlap the first active layer ACT1 of the switching transistor ST and overlap a portion of the second active layer ACT2 of the driving transistor DT, and may not overlap the other portion of the second active layer ACT2. That is, the second active layer ACT2 of the driving transistor DT may include a portion that overlaps neither the anode AND nor the intermediate electrode SD2.

Specifically, in FIG. 3, the anode AND and the intermediate electrode SD2 may not overlap a portion of the second active layer ACT2 of the driving transistor DT that does not overlap the second gate electrode G2, the second source electrode DSD1a, and the second drain electrode DSD1b.

Among the second active layer ACT2 of the driving transistor DT, a portion that does not overlap the anode AND and the intermediate electrode SD2 and is exposed to external light may overlap the bank 400.

For reference, FIG. 3 illustrates a case in which the driving transistor DT is connected to the anode AND through the intermediate electrode SD2 as an example, but the present disclosure is not limited thereto. That is, the driving transistor DT may be conductively connected to the anode AND through another switching transistor ST.

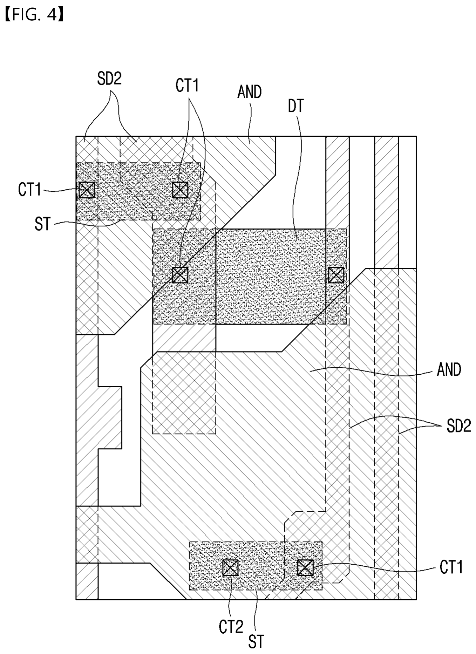

FIG. 4 is a diagram illustrating an overlapping relationship between the anode and the intermediate electrode and an overlapping relationship between the switching transistor and the driving transistor in the subpixel according to the present disclosure.

FIG. 4 illustrates, for convenience of understanding, an area where the anode AND and the intermediate electrode SD2 are disposed, an area where the switching transistor ST is disposed, and an area where the driving transistor DT is disposed, as an example. In FIG. 4, for example, the area where the switching transistor ST is disposed may be the same as the disposition location of the first active layer ACT1 of the switching transistor ST, and the area where the driving transistor DT is disposed may be the same as the disposition location of the second active layer ACT2 of the driving transistor DT. In FIG. 4, for the convenience of understanding, the remaining components of the subpixel SP (e.g., the source electrodes, the drain electrodes, the emission layer EL, etc.) are omitted.

As shown in FIG. 4, one side or the other side of each of the plurality of switching transistors ST and the driving transistor DT may be connected to the intermediate electrode SD2 through the first contact portion CT1, at least one of the plurality of switching transistors ST and the driving transistor DT may be conductively connected to each other through the intermediate electrode SD2, and the anode AND may be connected to the intermediate electrode SD2 through the second contact portion CT2.

A pattern forming the intermediate electrode SD2 and a pattern forming the anode AND may have an irregular shape, as shown in FIG. 4.

As shown in FIG. 4, the intermediate electrode SD2 and the anode AND may overlap the entirety of the first active layer ACT1 of the switching transistor ST, or the anode AND excluding the intermediate electrode SD2 may overlap the entirety of the first active layer ACT1. Alternatively, although not shown in FIG. 4, the intermediate electrode SD2 excluding the anode AND may overlap the entirety of the first active layer ACT1.

Accordingly, the present disclosure may prevent the first active layer ACT1 of the switching transistor ST from being exposed to external light and being subject to a negative shift.

On the other hand, as shown in FIG. 4, a portion of the second active layer ACT2 of the driving transistor DT may overlap the intermediate electrode SD2 and the anode AND, and the remaining portion of the second active layer ACT2 may overlap neither the intermediate electrode SD2 nor the anode AND.

Accordingly, the present disclosure, considering the characteristics of the driving transistor DT that is stressed in the direction of a positive shift due to characteristics of a driving method, such as the compensation circuit, causes at least a portion of the second active layer ACT2 of the driving transistor DT to be exposed to external light, as described with reference to FIGs. 3 and 4, thereby being capable of offsetting a phenomenon in which the threshold voltage Vth of the driving transistor DT shifts positively.

Hereinafter, the region of the driving transistor DT exposed to external light will be described in more detail.

FIGs. 5(a) and 5(b) are diagrams illustrating the non-overlapping portion of the driving transistor in the subpixel according to the present disclosure.

Specifically, FIG. 5(a) is an exemplary enlarged view showing a portion of the subpixel where the driving transistor DT is disposed, and FIG. 5(b) is a cross-sectional view taken along line CS-CS of FIG. 5(a).

For reference, in FIG. 5(a), for convenience of understanding, the second source electrode DSD1a, the second drain electrode DSD1b, the interlayer insulating film 200, the gate insulating film 150, and the second and third buffer layers 140b and 140c illustrated in FIG. 5(b) are omitted, and in FIG. 5(b), the anode AND illustrated in FIG. 5(a) is omitted.

As shown in FIGs. 5(a) and 5(b), the driving transistor DT may include the second metal layer BOT, the second active layer ACT2, the second gate electrode G2, the second source electrode DSD1a, and the second drain electrode DSD1b.

Specifically, as shown in FIGs. 5(a) and 5(b), in the driving transistor DT, the second metal layer BOT may be disposed to overlap the second active layer ACT2 and be conductively connected to the second source electrode DSD1a. The second gate electrode G2 may overlap the channel region of the second active layer ACT2. The second source electrode DSD1a may overlap and contact one side of the second active layer ACT2, and the second drain electrode DSD1b may overlap and contact the other side of the second active layer ACT2.

The second gate electrode G2 may be spaced apart from the second source electrode DSD1a and the second drain electrode DSD1b above the second active layer ACT2.

Portions of the second active layer ACT2 of the driving transistor DT that overlap the second gate electrode G2, the second source electrode DSD1a, and the second drain electrode DSD1b may be defined as non-exposed areas NEA.

In addition, portions of the second active layer ACT2 that do not overlap the second gate electrode G2, the second source electrode DSD1a, and the second drain electrode DSD1b may be defined as exposed areas EA. That is, the exposed areas EA of the second active layer ACT2 may be exposed to the outside from the second gate electrode G2, the second source electrode DSD1a, and the second drain electrode DSD1b.

In addition, first, second, and third intermediate electrodes SD2a, SD2b, and SD2c may be disposed on the second source electrode DSD1a and the second drain electrode DSD1b, the first intermediate electrode SD2a may be in contact with the second source electrode DSD1a through a first 1a contact portion CT1a, the second intermediate electrode SD2b may be in contact with the second gate electrode G2 through a first 1b contact portion CT1b, and the third intermediate electrode SD2c may be in contact with the second drain electrode DSD1b through a first 1c contact portion CT1c.

In addition, although not shown in FIG. 5(b), as shown in FIG. 5(a), the anode AND may be disposed to overlap some of the intermediate electrodes SD2a, SD2b, and SD2c. For example, as in FIG. 5(a), the anode AND may be conductively connected to the first intermediate electrode SD2a through the second contact portion CT2, and may overlap the entirety of the first intermediate electrode SD2a or a portion of the second intermediate electrode SD2b. In addition, the anode AND located above the second drain electrode DSD1b of the driving transistor DT may overlap most of the third intermediate electrode SD2c excluding a portion of the third intermediate electrode SD2c.

The present disclosure may prevent the exposed areas EA of the second active layer ACT2 of the driving transistor DT from overlapping the anode AND and the first, second, and third intermediate electrodes SD2a, SD2b, and SD2c. Therefore, external light may penetrate between the anode AND and the first, second, and third intermediate electrodes SD2a, SD2b, and SD2c and be incident on the exposed areas EA of the second active layer ACT2. Accordingly, the present disclosure may further increase the amount of carriers included in the second active layer ACT2 through the incident external light, thereby being capable of offsetting the positive bias thermal stress (PBTS) received by the driving transistor DT.

Hereinafter, the principle in which the positive bias thermal stress (PBTS) of the driving transistor DT is offset by external light will be described.

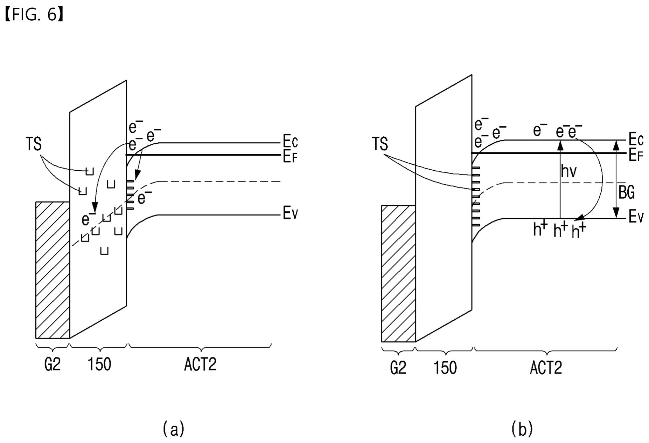

FIGs. 6(a) and 6(b) are diagrams illustrating the principle in which the positive bias thermal stress (PBTS) of the driving transistor DT is offset.

FIG. 6(a) illustrates an energy band diagram for explaining that the driving transistor DT is deteriorated when the driving transistor DT is not exposed to external light, and FIG. 6(b) illustrates an energy band diagram for explaining that the deterioration of the driving transistor DT is offset or prevented when the driving transistor DT is exposed to external light.

In FIGs. 6 (a) and 6(b), E_{c} may denote a conduction band formed in the second active layer ACT2, Eᵥ may denote a valence band, E_{F} may denote a Fermi level, and TS may denote a trap site where carriers are trapped at the interface between the second active layer ACT2 and the gate insulating film 150.

Hereinafter, a case in which the driving transistor DT is an n-type having electrons (e-) as carriers will be described as an example.

As described above with reference to FIGs. 1 and 2, when a positive (+) voltage is continuously applied to the second gate electrode G2 of the driving transistor DT by the compensation circuit or the like, as shown in FIG. 6(a), some of electrons (e-) moving through the conduction band E_{c} of the second active layer ACT2 may be trapped in the trap site TS located at the boundary between the second active layer ACT2 and the gate insulating film 150 by the positive (+) voltage continuously applied to the second gate electrode G2.

As the driving time of the driving transistor DT increases, the amount of electrons (e-) trapped in the trap site TS accumulates, and the driving current of the driving transistor DT may gradually decrease. Accordingly, as the driving time of the display panel increases, a phenomenon in which the brightness of the light-emitting element OLED gradually decreases may occur.

However, as described above with reference to FIGs. 3 to 5, when the exposed areas EA of the second active layer ACT2 provided in the driving transistor DT are exposed to external light, as shown in FIG. 6(b), electrons (e⁻) in the valence band Eᵥ may be excited to the conduction band Ec and holes (h⁺) may be formed in the valence band Eᵥ by the energy hv of the external light having a value greater than a band gap BG, so that a large number of electron-hole pairs may be formed within the second active layer ACT2. In this way, the present disclosure may supplement the amount of electrons (e⁻) reduced by trapping using electrons (e⁻) excited to the conduction band E_{c} by external light, and may minimize the reduction in the amount of driving current.

In addition, some of the holes (h⁺) generated by the external light may be combined with the trapped electrons (e⁻) to reduce the amount of the trapped electrons (e⁻), and when the positive (+) voltage applied to the second gate electrode G2 of the driving transistor DT is released, electrons (e⁻) and holes (h⁺) may be immediately recombined and quickly return to an equilibrium state, thereby being capable of suppressing the positive shift of the threshold voltage Vth of the driving transistor DT.

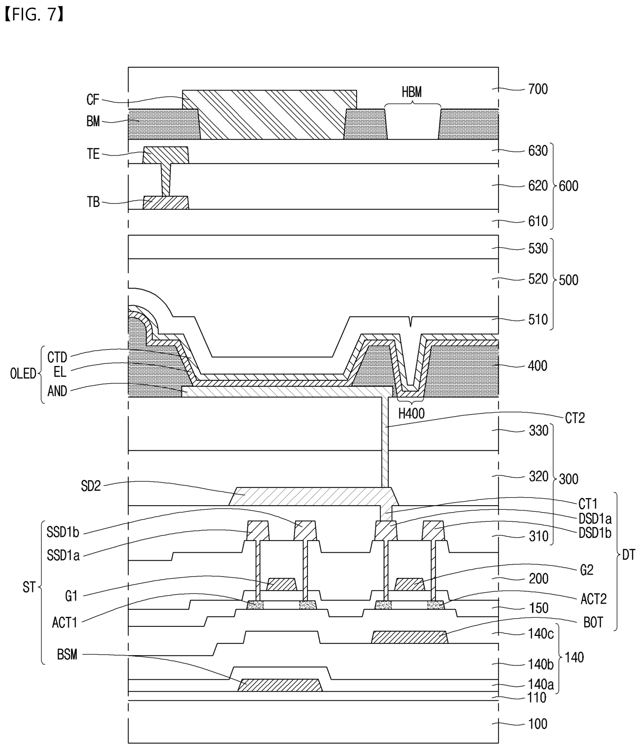

FIG. 7 is a diagram illustrating a cross-sectional structure of a display panel according to another embodiment of the present disclosure.

In the description of FIG. 7, content that overlaps the description given above with reference to FIGs. 3 to 6(b) is omitted, and the following description focuses on parts different from those of FIGs. 3 to 6(b).

The example of the cross-sectional structure of the display panel shown in FIG. 7 may represent a cross-sectional structure of a subpixel. As shown in FIG. 7, the cross-sectional structure of the display panel 10 according to another embodiment of the present disclosure may include a substrate 100, a substrate insulating film 110, a buffer layer 140, a gate insulating film 150, an interlayer insulating film 200, a planarization film 300, an intermediate electrode SD2, a bank 400, a light-emitting element OLED, an encapsulation layer 500, a switching transistor ST, and a driving transistor DT, and a touch insulating film 600, a touch electrode TE, a bridge electrode TB, a black matrix BM, a color filter CF, and an upper planarization film 700 may be further located on the encapsulation layer 500.

Here, the description of the substrate 100, the substrate insulating film 110, the buffer layer 140, the gate insulating film 150, the interlayer insulating film 200, the planarization film 300, the intermediate electrode SD2, the light-emitting element OLED, the encapsulation layer 500, the switching transistor ST, and the driving transistor DT excluding the bank 400 that overlaps the description given with reference to FIGs. 3 to 6(b) is omitted.

As shown in FIG. 7, the bank 400 may include a light-absorbing material. For example, the bank 400 may include a black pigment, such as carbon black. Accordingly, the bank 400 may absorb external light to minimize light reflectivity, further enhance black color, and improve contrast ratio and color accuracy to further improve image quality.

As shown in FIG. 7, the bank 400 may have bank holes H400 formed through some areas thereof, and the bank holes H400 may overlap exposed areas EA of the driving transistor DT.

In addition, at least one of an emission layer EL or a cathode CTD may be located within the bank holes H400, and an anode AND may not overlap the bank holes H400.

In this way, the present disclosure allows the bank holes H400 to overlap the exposed areas EA of the driving transistor DT and allows at least one of the emission layer EL or the cathode CTD having high light transmittance to be located in the bank holes H400, when the bank 400 includes a light-absorbing material, thereby allowing external light to be incident upon the exposed areas EA of the driving transistor DT through the bank holes H400.

Accordingly, the present disclosure may suppress the positive shift of the threshold voltage Vth of the driving transistor DT due to the positive bias thermal stress (PBTS).

The touch insulating film 600 may be provided by stacking a plurality of layers including an organic insulating material or an inorganic insulating material.

For example, the touch insulating film 600 may include first, second, and third touch insulating films 610, 620, and 630.

The first touch insulating film 610 may be disposed on the third encapsulation layer 530, and the bridge electrode TB connected to the touch electrode TE may be patterned and disposed on the first touch insulating film 610.

The second touch insulating film 620 may be disposed on the first touch insulating film 610 while covering the bridge electrode TB, and the touch electrode TE may be disposed on the second touch insulating film 620. The touch electrode TE may penetrate the second touch insulating film 620 and be conductively connected to the bridge electrode TB.

The touch electrode TE may include a touch driving electrode (not shown) that transmits a touch driving signal and a touch receiving electrode (not shown) that senses the touch driving signal, the touch driving electrode and the touch receiving electrode may be arranged in a matrix, the touch driving electrode may extend in a first direction, and the touch receiving electrode may extend in a second direction intersecting the first direction.

One electrode of the touch driving electrode and the touch receiving electrode may be spaced apart from an intersection where they intersect each other, and the electrode spaced apart from the intersection may be connected through the bridge electrode TB.

The third touch insulating film 630 may be disposed on the second touch insulating film 620 while covering the touch electrode TE.

The black matrix BM may be disposed on the third touch insulating film 630 and include a light-absorbing material, for example, a black pigment. The black matrix BM may overlap the bank 400.

The color filter CF may be disposed on the third touch insulating film 630, be disposed between portions of the black matrix BM, and overlap the emission area of the light-emitting element OLED. The color filter CF may have the same color as the color of light emitted by the light-emitting element OLED, and may make the color of the light emitted by the light-emitting element OLED clearer.

The black matrix BM may have black matrix (BM) holes HBM formed through some areas thereof, and the BM holes HBM may overlap the bank holes H400 and overlap the exposed areas EA of the driving transistor DT. Thereby, external light may be incident on the exposed areas EA of the driving transistor DT through the BM holes HBM and the bank holes H400.

The upper planarization film 700 may be disposed on the color filter CF and the black matrix B, include an insulating material having high fluidity, and remove steps formed by the color filter CF and the black matrix BM.

The upper planarization film 700 may fill the insides of the BM holes HBM, and may be in contact with the third touch insulating film 630 through the BM holes HBM.

In this way, even when the bank 400 and the black matrix BM including the light-absorbing material are provided, the present disclosure may expose the driving transistor DT to external light through the bank holes H400 and the BM holes HBM that overlap the exposed areas EA of the driving transistor DT.

Accordingly, the present disclosure may expose at least a portion of the driving transistor DT excluding the switching transistor ST to external light, thereby being capable of suppressing the positive shift of the threshold voltage of the driving transistor DT due to the positive bias thermal stress (PBTS) and thus further improving the reliability of the display panel 10.

As is apparent from the above description, a display panel according to one embodiment of the present disclosure has a structure in which a first active layer of a switching transistor overlap at least one of an anode or an intermediate electrode, and at least a portion of a second active layer of a driving transistor does not overlap the anode and the intermediate electrode, thereby being capable of suppressing the positive shift of a threshold voltage of the driving transistor due to positive bias thermal stress (PBTS) and thus further improving the reliability of the display panel.

## Claims

1. A display panel (10) comprising:
a substrate (100);
a switching transistor (ST) disposed on the substrate (100) and comprising a first gate electrode (G1), a first source electrode (SSD1a), a first drain electrode (SSD1b), and a first active layer (ACT1);
a driving transistor (DT) disposed on the substrate (100) to be spaced apart from the switching transistor (ST) and comprising a second gate electrode (G2), a second source electrode (DSD1a), a second drain electrode (DSD1b), and a second active layer (ACT2);
a light-emitting element (OLED) comprising an anode (AND) conductively connected to one electrode of the second source electrode (DSD1a) and the second drain electrode (DSD1b) of the driving transistor (DT), an emission layer (EL) located on the anode (AND), and a cathode (CTD) located on the emission layer (EL); and
an intermediate electrode (SD2) configured to conductively connect the one electrode of the second source electrode (DSD1a) and the second drain electrode (DSD1b) of the driving transistor (DT) to the anode (AND),
wherein:
the first active layer (ACT1) of the switching transistor (ST) overlaps at least one of the anode (AND) and the intermediate electrode (SD2); and
at least a portion of the second active layer (ACT2) of the driving transistor (DT) does not overlap the anode (AND) and the intermediate electrode (SD2).

2. The display panel (10) according to claim 1, wherein an entirety of the first active layer (ACT1) of the switching transistor (ST) overlaps the at least one of the anode (AND) and the intermediate electrode (SD2).

3. The display panel (10) according to claim 1 or 2, wherein the first active layer (ACT1) and/or the second active layer (ACT2) comprise an oxide semiconductor.

4. The display panel (10) according to any of claims 1 to 3, wherein the second active layer (ACT2) of the driving transistor (DT) comprises:
non-exposed areas (NEA) configured to overlap the second gate electrode (G2), the second source electrode (DSD1a), and the second drain electrode (DSD1b); and
exposed areas (EA) configured not to overlap the second gate electrode (G2), the second source electrode (DSD1a), and the second drain electrode (DSD1b),
wherein at least the exposed areas (EA) of the second active layer (ACT2) of the driving transistor (DT) do not overlap the anode (AND) and the intermediate electrode (SD2).

5. The display panel (10) according to claim 4, further comprising a bank (400), wherein at least the exposed areas (EA) of the second active layer (ACT2) of the driving transistor (DT) overlap the bank (400).

6. The display panel (10) according to claim 5, wherein the bank (400) comprises a light-absorbing material.

7. The display panel (10) according to claim 5 or 6, wherein:
the bank (400) has bank holes (H400) formed through some areas thereof; and
at least one of the emission layer (EL) or the cathode (CTD) is located in the bank holes (H400).

8. The display panel (10) according to claim 7, wherein the anode (AND) does not overlap the bank holes (H400).

9. The display panel (10) according to claim 7 or 8, wherein the bank holes (H400) overlap the exposed areas (EA) of the second active layer (ACT2) of the driving transistor (DT).

10. The display panel (10) according to any of claims 7 to 9, further comprising:
a black matrix (BM) disposed above the light-emitting element (OLED); and
a color filter (CF) disposed between portions of the black matrix (BM).

11. The display panel (10) according to claim 10, wherein the color filter (CF) overlaps an emission area of the light-emitting element (OLED).

12. The display panel (10) according to claim 10 or 11, wherein the black matrix (BM) comprises a light-absorbing material and overlaps the bank (400).

13. The display panel (10) according to any of claims 10 to 12, wherein the black matrix (BM) has black matrix (BM) holes (HBM) formed through some areas thereof.

14. The display panel (10) according to claim 13, wherein the BM holes (HBM) overlap the bank holes (H400).

15. The display panel (10) according to claim 13 or 14, wherein the BM holes (HBM) overlap the exposed areas (EA) of the second active layer (ACT2) of the driving transistor (DT).
